# EUROPEAN PATENT APPLICATION

(11) **EP 4 510 192 A1**
(43) Date of publication of application: **19.02.2025**
(21) Application number: 23197902.2
(22) Date of filing: 18.09.2023
(51) Int. Cl.: H01L 29/06, H01L 29/78

(54) **POWER SEMICONDUCTOR DEVICE AND POWER CONVERTER**

(30) Priority: 18.08.2023 KR 20230108439
(71) Applicant: LX Semicon Co., Ltd., Daejeon 34027 (KR)
(72) Inventor: PARK, Jin Ok, 34027 Daejeon (KR); KANG, Nam Ju, 34027 Daejeon (KR); SONG, Seung Wook, 34027 Daejeon (KR); LEE, Doo Hyung, 34027 Daejeon (KR); HONG, Kuk Tae, 34027 Daejeon (KR)
(74) Representative: Ter Meer Steinmeister & Partner

(57) **Abstract**

A power semiconductor is disclosed and for high-voltage and high-power operation. An example power semiconductor comprises: a substrate; a drift layer formed in the substrate including an active area having doped regions and a termination area configured to surround the active area; and a junction termination extension (JTE) in the termination area. In some aspects, the substrate and the drift layer comprise a first conductivity type, the doped regions and the JTE comprise a second conductivity type, the JTE comprises at least one blocking region adjacent to an edge of the active area and a plurality of separation regions, each separation region of the plurality of separation regions comprises two or more separation sub-regions, and the two or more separation sub-regions are configured to have a different dopant concentrations.

## Description

### BACKGROUND

### 1. Technical field

The instant disclosure relates to a power semiconductor device and a power converter.

### 2. Description of the related art

Unlike a system semiconductor or a memory that processes and stores information or signals, a power semiconductor converts, stores, distributes, and controls power entering electronic devices, and is widely used in most electronic products.

In recent years, in line with the global trend of strengthening environmental protection, electric or hydrogen-based eco-friendly vehicles have been widely spotlighted instead of existing fossil fuel-based vehicles. Numerous power semiconductor devices are used in these eco-friendly vehicles. Here, the eco-friendly vehicle includes a hybrid electric vehicle (HEV), a plug-in hybrid vehicle (PHEV), an electric vehicle (EV), a fuel cell electric vehicle (PCEV) or the like.

In the related art, a silicon (Si) power semiconductor device has been widely used, but the development of a new power semiconductor device is needed for low power, low dielectric breakdown characteristics, and low thermal conductivity.

Accordingly, research on a power semiconductor based on a semiconductor compound having an energy band gap that is about three times higher than that of the Si power semiconductor device in the related art has been actively conducted. The power semiconductors based on the semiconductor compound include high power, high dielectric breakdown characteristics, and high thermal conductivity.

Recently, power semiconductors are adopted for ultra-high voltage transmission facilities or electric vehicles, a high breakdown voltage is required. For example, a breakdown voltage of 1,200V or more is required.

To this end, research on the design and layout of a power semiconductor device having a satisfactory breakdown voltage is being actively conducted.

### SUMMARY

The instant disclosure is related to addressing the foregoing and other problems.

Another object of the aspect is to provide a power semiconductor device and a power converter having a novel structure.

Another object of the aspect is to provide a power semiconductor device and a power converter capable of withstanding a high breakdown voltage.

Another object of the embodiments is to provide a power semiconductor device and a power converter capable of designing an optimized space without design rule restrictions.

The technical problems of the embodiments are not limited to those described in this section, and include those that may be understood through the description of the disclosure.

According to a first aspect of the aspect to achieve the above or other object, a power semiconductor device, comprising: a substrate comprising an active area and a termination area configured to surround the active area; a drift layer on the substrate; bodies on the drift layer in the active area; and a junction termination extension (JTE) on the drift layer in the termination area, wherein the substrate and the drift layer comprise a first conductivity type dopant, wherein the bodes and the JTE comprise a second conductivity type dopant, wherein the JTE comprises at least one blocking region and a plurality of separation regions located farther from the outermost body than the at least one blocking region, wherein each of the plurality of separation regions comprises two or more sub-regions, and wherein the two or more sub-regions have different doses.

Each of the plurality of separation regions may comprise a first sub-region comprising a first dose; and a second sub-region comprising a second dose, and the first dose may be greater than the second dose.

The first sub-region may be located closer to the outermost body than the second sub-region.

When a plurality of separation intervals are defined by a first separation interval and the remaining separation intervals, the first separation interval may be smaller than each of the remaining separation intervals, the first separation interval may be an interval between a first sub-region of a first separation region closest to the blocking region among the plurality of separation regions and the blocking region, and the remaining spacing intervals may be intervals between the plurality of first sub-regions of the plurality of separation regions.

As the distance from the outermost body increases, the first separation interval and the remaining separation intervals may increase.

The first sub-region and the second sub-region may have different thicknesses.

The upper side of the first sub-region and the upper side of the second sub-region may be located at the same horizontal line, and the lower side of the second sub-region may be located lower than the lower side of the first sub-region.

Each of the plurality of separation regions may comprise an overlapping region comprising a part of the first sub-region and a part of the second sub-region.

The lower side of the second sub-region may be located below the overlapping region.

A first dose of the first sub-region or a second dose of the second sub-region may be equal to the dose of the body.

According to a second aspect of the aspect to achieve the above or other object, a power semiconductor device, comprising: a substrate comprising an active area and a termination area configured to surround the active area; a drift layer on the substrate; bodies on the drift layer in the active area; and a JTE on the drift layer in the termination area, wherein the substrate and the drift layer comprise a first conductivity type dopant, wherein the body and the JTE comprise a second conductivity type dopant, wherein the JTE comprises at least one blocking region and a plurality of separation regions, wherein the at least one blocking region is in contact with the side portion of the outermost body, wherein the plurality of separation regions are disposed along a lateral direction of the at least one blocking region, wherein each of the plurality of separation regions comprises: a first sub region having a first dose; and a second sub-region having a second dose, wherein the first dose is greater than the second dose.

When a plurality of separation intervals are defined by a first separation interval and the remaining separation intervals, the first separation interval may be smaller than each of the remaining separation intervals, the first separation interval may be an interval between a first sub-region of a first separation region closest to the blocking region among the plurality of separation regions and the blocking region, and the remaining spacing intervals may be intervals between the plurality of first sub-regions of the plurality of separation regions.

As the distance from the outermost body increases, the first separation interval and the remaining separation intervals may increase.

The first sub-region and the second sub-region may have different thicknesses.

The upper side of the first sub-region and the upper side of the second sub-region may be located at the same horizontal line, and the lower side of the second sub-region may be located lower than the lower side of the first sub-region.

Each of the plurality of separation regions may comprise an overlapping region comprising a part of the first sub-region and a part of the second sub-region.

The lower side of the second sub-region may be located below the overlapping region.

A first dose of the first sub-region or a second dose of the second sub-region may be equal to the dose of the body.

The at least one blocking region and the plurality of separation regions may have a ring shape.

According to a third aspect of the embodiments to achieve the above or other object, a power converter, comprising: a plurality of power semiconductor modules, wherein each of the plurality of power semiconductor modules comprises a plurality of power semiconductor devices, wherein each of the plurality of power semiconductor devices comprises: a substrate comprising an active area and a termination area configured to surround the active area; a drift layer on the substrate; bodies on the drift layer in the active area; and a JTE on the drift layer in the termination area, wherein the substrate and the drift layer comprise a first conductivity type dopant, wherein the bodes and the JTE comprise a second conductivity type dopant, wherein the JTE comprises at least one blocking region and a plurality of separation regions located farther from the outermost body than the at least one blocking region, wherein each of the plurality of separation regions comprises two or more sub-regions, and wherein the two or more sub-regions have different doses.

Effects of the power semiconductor device and the power converter according to the aspect will be described below.

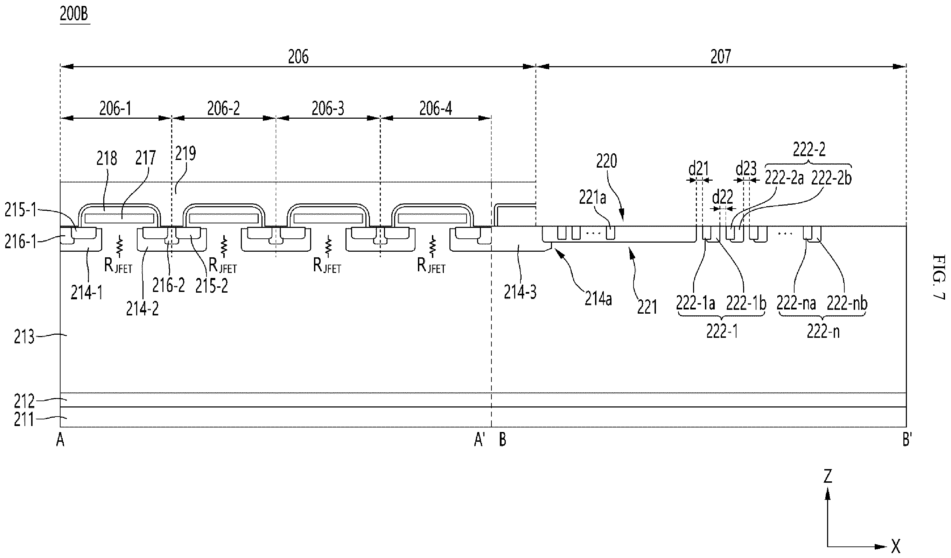

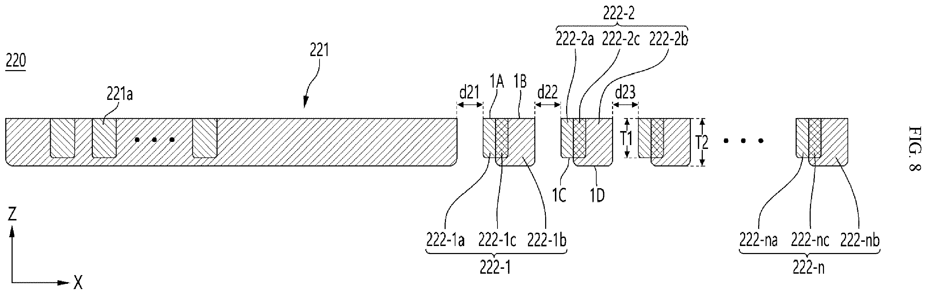

As shown in FIGS. 7 and 8, the power semiconductor device according to the aspect may comprise a termination area 207 disposed on a side portion 214a of a body located at the outermost part of an active area 206 (hereinafter, the outermost body 214-3). The termination area 207 comprises a blocking region 221 in contact with the outermost body 214-3 and a plurality of separation regions 222-1 to 222-n disposed along a lateral direction of the blocking region 221.

The plurality of separation regions 222-1 to 222-n may comprise two or more sub-regions. For example, a plurality of first sub-regions 222-1a to 222-na of the plurality of separation regions 222-1 to 222-n may be located closer to the outermost body 214-3 than a plurality of second sub-regions 222-1b to 222-nb.

Since a plurality of separation intervals d21 to d23 are minimized by the first sub-regions 222-1a to 222-na, an optimized space may be designed without design rule restrictions. The second sub-regions 222-1b to 222-nb may appropriately disperse the electric field. Accordingly, according to the aspect, an optimized space may be designed without design rule restrictions through the first sub-regions 222-1a to 222-na, and the desired withstanding voltage may be achieved through the second sub-regions 222-1b to 222-nb.

For example, the first sub-regions 222-1a to 222-na of the first separation region 222-1 adjacent to the outermost body 214-3 may be formed with a first separation interval d21 of 1 micrometer or less from the outermost body 214-3. In addition, the plurality of first sub-regions 222-1a to 222-na of the plurality of separation regions 222-1 to 222-n may be formed such that the remaining separation intervals d22 and d23 are also set very narrow. Therefore, it is possible to design an optimized space without design rule restrictions.

For example, since each of the plurality of separation regions 222-1 to 222-n may comprise the second sub-region 222-1b to 222-nb having a second dose smaller than a first dose of the first sub-regions 222-1a to 222-na, even a very large electric field may be appropriately dispersed by the second sub-regions 222-1b to 222-nb of the plurality of separation regions 222-1 to 222-n, respectively. Thus, a further increased withstanding voltage may be secured

A further scope of applicability of the aspect will become apparent from the detailed description that follows. However, since various changes and modifications within the spirit and scope of the aspect may be clearly understood by those skilled in the art, it should be understood that the detailed description and specific aspect, such as preferred aspect, are given by way of example only.

### BRIEF DESCRIPTION OF THE DRAWINGS

FIG. 1 is a circuit diagram illustrating an automotive inverter according to a first aspect.
FIG. 2 is a plan view illustrating a power semiconductor device according to an aspect.
FIG. 3 is an enlarged plan view illustrating a region X of FIG. 2.
FIG. 4 is a cross-sectional view in which a region X shown in FIG. 3 is taken along line C-C'.
FIG. 5 is a cross-sectional view in which a region X shown in FIG. 3 is taken along line D-D'.
FIG. 6 is a cross-sectional view illustrating a power semiconductor device according to a first aspect.
FIG. 7 is a cross-sectional view illustrating a power semiconductor device according to a second aspect.
FIG. 8 is an enlarged cross-sectional view illustrating a junction termination extension (JTE) in the power semiconductor device according to the second aspect shown in FIG. 7.
FIG. 9 is a graph illustrating a breakdown voltage according to dose in an aspect.

### DETAILED DESCRIPTION

Hereinafter, the aspect disclosed in this specification will be described in detail with reference to the accompanying drawings, but the same or similar elements are given the same reference numerals regardless of reference numerals, and redundant descriptions thereof will be omitted. The suffixes "module" and "unit" for the elements used in the following descriptions are given or used interchangeably in consideration of ease of writing the specification, and do not themselves have a meaning or role that is distinct from each other. In addition, the accompanying drawings are for easy understanding of the aspect disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

In an aspect, the power converter is used for inverters or converters such as computers, home appliances, automobiles, solar power, and smart grids. In an aspect, the power converter may comprise one power semiconductor module or a plurality of power semiconductor modules. In addition, the power semiconductor module may comprise a plurality of power semiconductor devices.

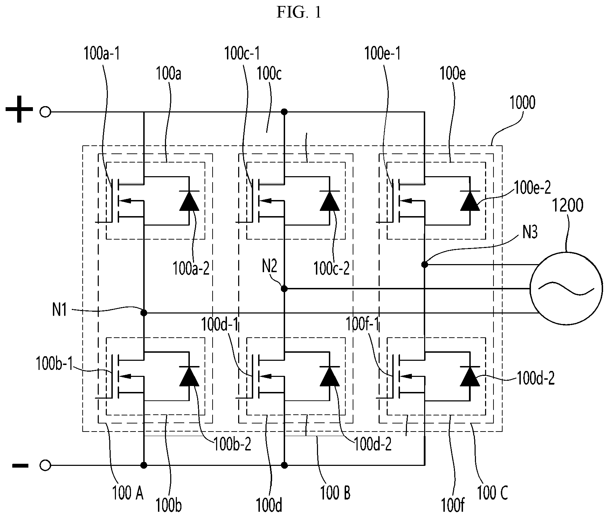

In the following aspects, for example as shown in FIGs. 1 and 11, an inverter for driving a motor of a vehicle is described as a power semiconductor device, but the power converter of the aspect may be applied to any suitable inverter or converter. In some cases, the vehicle may be an eco-friendly vehicle, and may comprise an electric vehicle (EV), a hybrid EV (HEV), a plugin hybrid EV (PHEV), passenger car equivalent vehicles (PCEV) or the like.

In the following aspect, a withstanding voltage and a breakdown voltage may be used interchangeably.

In the following aspects, a switching device and a power semiconductor device may be used interchangeably and a leg and a power semiconductor module may be used interchangeably.

FIG. 1 is a circuit diagram illustrating an automotive inverter according to a first aspect.

Referring to FIG. 1, an inverter 1000 according to the first aspect may convert a direct current (DC) power into alternating current (AC) power and supply the converted AC power to a load 1200 to drive the load 1200. In the inverter 1000 according to the first aspect, a battery may be connected to an input terminal so that DC power of the battery may be converted into AC power. Although not shown, a converter may be connected to the input terminal of the battery, and an input terminal of the converter may be connected to a charger of a charging station. In this case, AC power supplied through the charger may be converted into DC power by the converter to charge the battery. In addition, the DC power charged in the battery may be converted into AC power by the inverter 1000 according to the first aspect and may be used to drive the load.

The circuit configuration of the converter may be similar or identical to that of the inverter.

The load 1200 may be a motor but is not limited thereto.

The inverter 1000 according to the first aspect may comprise a 3-phase inverter but is not limited thereto. For example, a 3-phase inverter may output AC currents having a phase difference of 120 degrees between the first phase, the second phase, and the third phase. The inverter 1000 according to the first aspect may comprise a plurality of legs 100A, 100B, and 100C. For example, the first leg 100A, the second leg 100B, and the third leg 100C may be connected in parallel to the load, i.e., the motor through a first node N1, a second node N2, and a third node N3, respectively. The first leg 100A may include a first arm 100a and a second arm 100b connected in series with each other, and the second leg 100B may include a third arm 100c and a fourth arm 100d connected in series with each other, and the third leg 100C may include a fifth arm 100e and a sixth arm 100f connected in series with each other. The first arm 100a, the third arm 100c, and the fifth arm 100e may be called an upper arm, and the second arm 100b, the fourth arm 100d, and the sixth arm 100f are called a lower arm. Each of the first arm 100a to sixth arms 100f may be referred to as a switching module or submodule.

The first arm 100a to the sixth arm 100f may include switching devices 100a-1, 100b-1, 100c-1, 100d-1, 100e-1, and 100f-1 and diodes 100a-2 and 100b-2, 100c-2, 100d-2, 100e-2, and 100f-2, respectively. The switching devices 100a-1, 100b-1, 100c-1, 100d-1, 100e-1, 100f-1 and the diodes 100a-2, 100b-2, 100c-2, 100d-2, 100e-2, 100f-2) may be formed simultaneously using the same semiconductor process. The switching devices 100a-1, 100b-1, 100c-1, 100d-1, 100e-1, and 100f-1 may include a power semiconductor device, respectively.

To convert DC power into AC power by the inverter according to the first aspect, the switching devices 100a-1, 100b-1, 100c-1, and 100d-1, 100e-1, and 100f-1 of each of the first arm 100a to the sixth arm 100f may be on/off controlled.

For example, when the first switching device 100a-1 of the first arm 100a of the first leg 100A is in an on state, the diode 100d-1 of the fourth arm 100d of the second leg 100B and/or the sixth switching device 100f 1 of the sixth arm 100f of the third leg 100C may be turned on. Accordingly, DC power may be supplied to the first phase inductor of the motor.

For example, when the second switching device 100b-1 of the second arm 100b of the second leg 100B is in an on state, the sixth switching device 100f-1 of the sixth arm 100f of the third leg 100C and/or the second switching device 100b-1 of the second arm 100b of the first leg 100A may be turned on. Accordingly, DC power may be supplied to the second phase inductor of the motor. The second phase may be delayed by 120 degrees from the first phase.

For example, when the third switching device 100c-1 of the third arm 100c of the third leg 100C is in an on state, the second switching device 100b-1 of the second arm 100b of the first leg 100A and/or the diode 100d-1 of the fourth arm 100d of the second leg 100B may be turned on. Accordingly, DC power may be supplied to the third phase inductor of the motor. The third phase may be delayed by 120 degrees from the second phase.

Accordingly, AC power may be generated by the DC power supplied to each of the first phase inductor, the second phase inductor, and the third phase inductor.

Meanwhile, although not shown, the switching devices of each of the first arm 100a to sixth arm 100f, that is, the switching devices 100a-1, 100b-1, 100c-1, 100d-1, 100e-1, 100f-1 may be connected in series with each other.

Although not shown, the switching devices of each of the first arm 100a to sixth arm 100f, that is, the switching devices 100a-1, 100b-1, 100c-1, 100d-1, 100e-1, 100f-1 may be provided in a plurality connected in parallel with each other.

In some cases, the switching devices 100a-1, 100b-1, 100c-1, 100d-1, 100e-1, and 100f-1 and the diode 100a-2, 100b-2, 100c-2, 100d-2, 100e-2, 100f-2 corresponding to the first arm 100a to the sixth arm 100f may be packaged and configured as a power semiconductor module

As an example, each of the first leg 100A, the second leg 100B, and the third leg 100C may be configured as a power semiconductor module. That is, the first arm 100a and the second arm 100b of the first leg 100A may be packaged to form a first power semiconductor module. The third arm 100c and the fourth arm 100d of the second leg 100B may be packaged to form a second power semiconductor module. The fifth arm 100e and the sixth arm 100f of the third leg 100C may be packaged to form a third power semiconductor module.

As another example, the first leg 100A, the second leg 100B, and the third leg 100C may be configured as a single power semiconductor module. That is, the first arm 100a and the second arm 100b of the first leg 100A, the third arm 100c and the fourth arm 100d of the second leg 100B, and the fifth arm 100e and the sixth arm 100f of the third leg 100C may be packaged to form a single power semiconductor module.

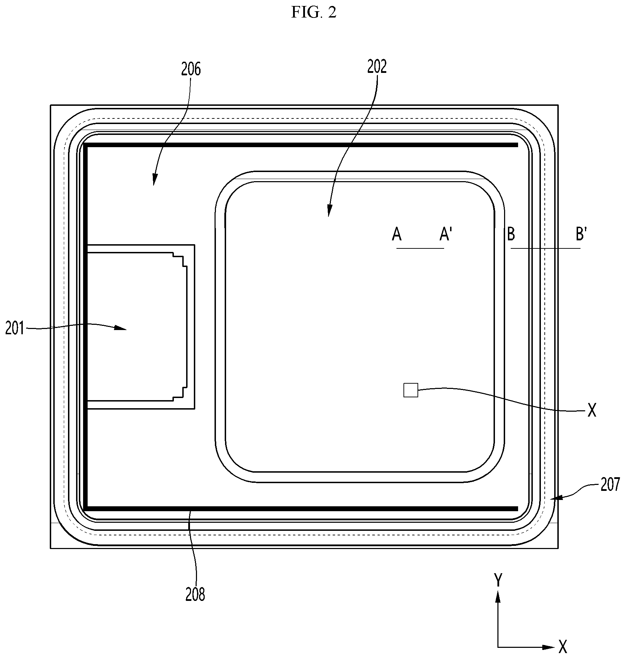

A power semiconductor device will be described below with reference to FIGS. 2 to 9. In the following description, components with doped regions having the same dose and formed on the same layer may be simultaneously formed through the same ion implantation process using the same mask. Alternatively, components having the same dose and formed on the same layer may be formed at different times with different masks.

The ion implantation process physically implants ions using a source gas into the substrate 212. The ions may be collectively referred to as impurities. Through the ion implantation process, various regions having different or identical doses may be formed by increasing a conductivity of an insulating material or changing it to semiconductive.

Hereinafter, a substrate, a drift layer, a body, a contact region, a source region, a blocking region, a separation region, or two or more sub-regions included in the separation region may be formed through the above-described ion implantation process. Different energies may be used in the various regions where ions are implanted according to their dopant concentration or position. For example, low energy may be used to implement a shallow junction, and high energy may be used to implement a deep junction, but this are not limited thereto.

In the following description, the terms dose, dose amount, and dopant concentration have the same meaning and may be used interchangeably.

FIG. 2 is a plan view illustrating a power semiconductor device according to an aspect.

Referring to FIG. 2, the power semiconductor device according to the aspect may be divided into an active area 206 and a termination area 207. The power semiconductor device according to the may be a Metal-Oxide-Semiconductor Field-Effect Transistor (MOSFET), but is not limited thereto.

The active area 206 may comprise a plurality of active cells. Each active cell may comprise a semiconductor device including a gate electrode 217, a source electrode 219, and a drain electrode 211 to perform a predetermined operation. Accordingly, a plurality of semiconductor devices may be configured by a plurality of active cells.

Since the plurality of active cells are defined in a matrix, a plurality of semiconductor devices may also be arranged in a matrix.

The termination area 207 may surround the active area 206. The termination area 207 may be located along an edge of the active area 206. The termination area 207 may enable a high breakdown voltage by dispersing an electric field.

In illustrated aspects, the power semiconductor device according to the aspect is shown as having a rectangular shape when viewed from the top, but the power semiconductor may have other shapes.

A gate pad 201 and a source pad 202 may be positioned in the active area 206. The gate pad 201 is connected to the gate electrode 217 of each active cell through a gate line 208 so that a gate signal may be supplied to the gate electrode 217. The source pad 202 is connected to the source electrode 219 of each active cell so that a source voltage may be supplied to the source electrode 219. Although not shown, a drain pad may be located on a lower side of the power semiconductor device according to the aspect. The drain pad may be connected to the drain electrodes 211 of each active cell so that a drain voltage may be supplied to the drain electrodes 211.

The gate electrode 217 may be called a gate, a gate poly, a gate contact, or the like. The source electrode 219 may be referred to as a source contact, and the gate electrode 217 may be referred to as a gate contact. Although not shown, the source pad 202 may be collectively referred to as the source electrode 219 without being distinguished from the source electrode 219, and the drain pad may be collectively referred to as the drain electrode 211 without being distinguished from the drain electrode 211.

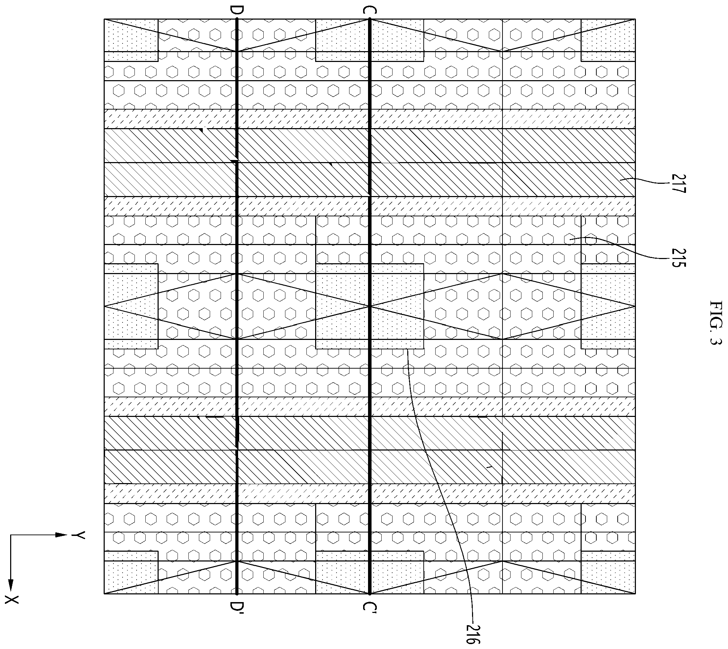

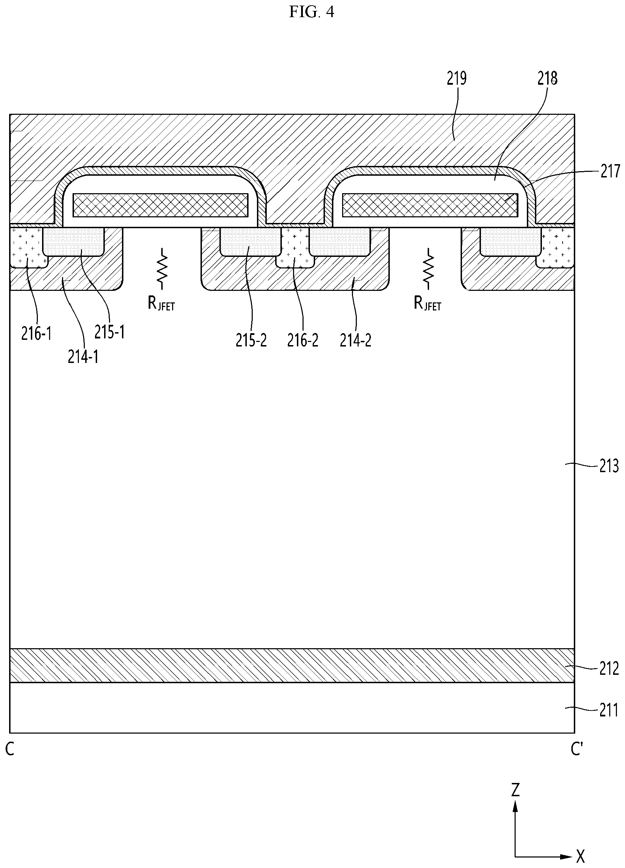

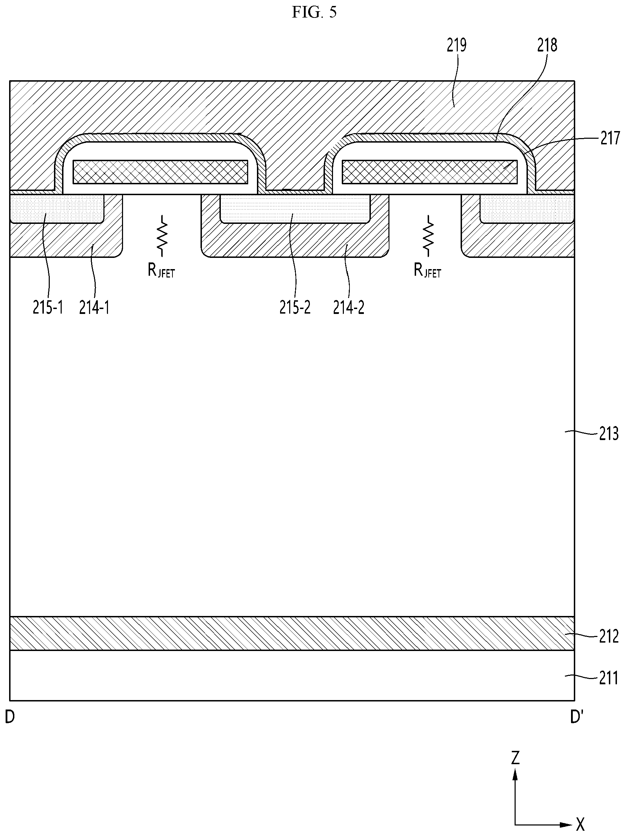

FIG. 3 is an enlarged plan view illustrating a region X of FIG. 2. FIG. 4 is a cross-sectional view in which a region X shown in FIG. 3 is taken along line C-C'. FIG. 5 is a cross-sectional view in which a region X shown in FIG. 3 is taken along line D-D'.

As shown in FIG. 3, six semiconductor devices are shown in the region X.

One active cell may include one semiconductor device, but is not limited thereto. For example, one active cell may include two or more semiconductor devices.

The power semiconductor device according to the aspect may comprise a drain electrode 211, a substrate 212, a drift layer 213, bodies 214-1 and 214-2, source regions 215 (e.g., source regions 215-1 and 215-2), and contact regions 216 (e.g., contact regions 216-1 and 216-2), a gate electrode 217, an insulating layer 218, and a source electrode 219. A semiconductor device including an active cell may comprise the substrate 212, the drift layer 213, the bodies 214-1 and 214-2, the source regions 215-1 and 215-2, and the contact regions 216-1 and 216-2, the gate electrode 217, the insulating layer 218, and the source electrode 219. Alternatively or additionally, the power semiconductor device according to the aspect may comprise additional components.

The drain electrode 211 may be disposed below the substrate 212. The drain electrode 211 may supply a drain voltage to the substrate 212. The drain electrode 211 may include a drain pad or a drain pad may be separately disposed below the drain electrode 211. The drain electrode 211 may be formed of Ni or other suitable material that forms an ohmic contact with an N-type silicon carbide (SiC).

The substrate 212 and/or the drift layer 213 may comprise a semiconductor compound such as SiC, gallium nitride (GaN), gallium oxide (Ga₂O₃), or the like. For example, the substrate 212 and/or the drift layer 213 may comprise a 4H-SiC material but is not limited thereto. For example, the substrate 212 and/or the drift layer 213 may comprise 3C-SiC or 6H-SiC.

The drift layer 213 may be disposed on the substrate 212. The drift layer 213 may be the substrate 212 or an epitaxial layer. The substrate 212 and the drift layer 213 may constitute a drain region, but are not limited thereto.

The drift layer 213 may comprise at least one or more drift region, but is not limited thereto. The drift layer 213 may be referred to as a drift region.

The substrate 212 and the drift layer 213 may have the same type of conductivity. For example, the substrate 212 and the drift layer 213 may have a first conductivity type. The first conductivity type may be N type, but is not limited thereto. To this end, the substrate 212 and the drift layer 213 may comprise an N-type dopant.

The bodies 214-1 and 214-2 may be formed separated from each other within the drift layer 213. The bodies 214-1 and 214-2 may have a second conductivity type. The bodies 214-1 and 214-2 may, for example, comprise a P-type dopant. When the bodies 214-1 and 214-2 comprise a P-type dopant, the bodies 214-1 and 214-2 may be referred to as a P-well. The bodies 214-1 and 214-2 may be referred to as a base region.

The contact regions 216-1 and 216-2 and the source regions 215-1 and 215-2 may be disposed in the bodies 214-1 and 214-2. The contact regions 216-1 and 216-2 may have the same conductivity type as the bodies 214-1 and 214-2, that is, the second conductivity type. The source regions 215-1 and 215-2 may have the same conductivity type as the drift region, that is, the first conductivity type. The source regions 215-1 and 215-2 and the contact regions 216-1 and 216-2 may be disposed adjacent to each other. The dopant concentration (P+) of the contact regions 216-1 and 216-2 may be greater than the dopant concentration (P-) of the bodies 214-1 and 214-2.

As shown in FIG. 3, the source regions 215-1 and 215-2 may have a stripe shape extending along one direction (e.g., the Y-axis direction). In contrast, the contact regions 216-1 and 216-2 may contact the bodies 214-1 and 214-2 by passing through the source regions 215-1 and 215-2. The contact regions 216-1 and 216-2 may be formed for each active cell but are not limited thereto.

The source electrode 219 may contact the contact regions 216-1 and 216-2 and the source regions 215-1 and 215-2. The source electrode 219 may be formed of nickel (Ni) or the like. An annealing process may be performed for the source electrode 219 to form an ohmic contact with the contact regions 216-1 and 216-2 and/or the source regions 215-1 and 215-2.

The source electrode 219 may be disposed on an entire area of the active area 206. The source electrode 219 may be disposed on the gate electrode 217. Although not shown, the source electrode 219 may not be disposed on the gate electrode 217 but may be disposed only on the contact regions 216-1 and 216-2 and the source regions 215-1 and 215-2.

The gate electrode 217 may be disposed on the drift layer 213 between the bodies 214-1 and 214-2 separated from each other. The gate electrode 217 may be surrounded by the insulating layer 218. The insulating layer 218 may be referred to as a gate oxide film. Another insulating layer may be disposed below the source electrode 219 but is not limited thereto.

In the semiconductor device having the above structure, channel layers between the drift layer 213 and the source regions 215-1 and 215-2 are conductive when the gate voltage is supplied to the gate electrode 217 and a current may flow between the source regions 215-1 and 215-2 and the drift layer 213. Therefore, the channel layers between the drift layer 213 and the source regions 215-1 and 215-2 may be conduct current or block current according to the gate voltage, thereby implementing a switching function.

### First aspect

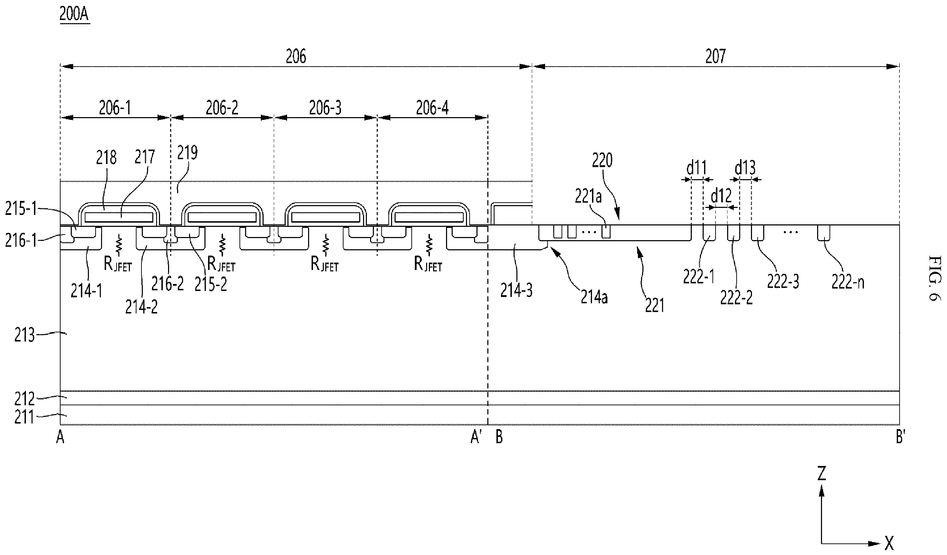

FIG. 6 is a cross-sectional view illustrating a power semiconductor device according to a first aspect. FIG. 6 is a cross-sectional view taken along line A-A' and line B-B', respectively in the power semiconductor device according to the aspect shown in FIG. 2.

As shown in FIG. 6, the power semiconductor device 200A may be divided into an active area 206 and a termination area 207. As described above, the active area 206 may comprise a plurality of active cells 206-1 to 206-4 each constituting a semiconductor device, and the termination area 207 may be located along the perimeter of the active area 206. The termination area 207 may provide a high breakdown voltage by dispersing an electric field. In one example, a breakdown voltage of 1, 200V or more may be generated by electric fields applied when the plurality of semiconductor devices included in the active area 206 operate. In this case, the termination area 207 may be positioned along the perimeter of the active area 206. Accordingly, since the electric fields are dispersed by the termination area 207, the power semiconductor device 200A may withstand a high breakdown voltage.

The power semiconductor device 200A according to the first aspect may comprise a drain electrode 211, a substrate 212, a drift layer 213, bodies 214-1 and 214-2, and source regions 215-1 and 215- 2, contact regions 216-1 and 216-2, a gate electrode 217, an insulating layer 218, and a source electrode 219.

The substrate 212 may comprise the active area 206 and the termination area 207. The active area 206 may comprise the plurality of active cells 206-1 to 206-4.

The drain electrode 211 is disposed below the substrate 212, and the drift layer 213, the bodies 214-1 and 214-2, the source regions 215-1 and 215-2, the contact regions 216-1 and 216-2, the gate electrode 217, the insulating layer 218, and the source electrode 219 may be disposed on the substrate 212.

The drain electrode 211 and the drift layer 213 may be respectively disposed on an entire area of the substrate 212. The bodies 214-1 and 214-2 may be disposed on the drift layer 213 between adjacent active cells 206-1 to 206-4. The source regions 215-1 and 215-2, the gate electrode 217, and the insulating layer 218 may be disposed in each of the active cells 206-1 to 206-4. The source regions 215-1 and 215-2 are disposed on the bodies 214-1 and 214-2, the gate electrode 217 is disposed on the drift layer 213, and the insulating layer 218 may surround the gate electrode. In particular, the insulating layer 218 may be positioned between the drift layer 213 and the gate electrode 217 to function as a gate oxide film. The contact regions 216-1 and 216-2 may be disposed between adjacent active cells 206-1 to 206-4. The contact regions 216-1 and 216-2 may be disposed on bodies 214-1 and 214-2. The contact regions 216-1 and 216-2 may contact the bodies 214-1 and 214-2 through the source regions 215-1 and 215-2 disposed between the adjacent active cells 206-1 to 206-4.

The source electrode 219 may be disposed on an entire area of the substrate 212. The source electrode 219 may be disposed on the active area 206. The source electrode 219 may not be disposed on the gate electrode 217, but may be disposed on the source regions 215-1 and 215-2.

A semiconductor device may be configured for each of the active cells 206-1 to 206-4 by the drain electrode 211, the substrate 212, the drift layer 213, the bodies 214-1 and 214-2, the source regions 215-1 and 215-2, the contact regions 216-1 and 216-2, the gate electrode 217, the insulating layer 218, and the source electrode 219.

Since four active cells 206-1 to 206-4 are shown in FIG. 6, four semiconductor devices corresponding to the active cells 206-1 to 206-4 may be included in the active area 206.

Meanwhile, the termination area 207 may be located at an outer edge (e.g., a border) of the active cell. As described above, the termination area 207 may surround the active cells 206-1 to 206-4. Accordingly, the active cells 206-1 to 206-4 and the termination area 207 may be positioned horizontally.

A junction termination extension (JTE) 220 may be disposed in the termination area 207. The JTE 220 may have the same conductivity type as a doped body located at the outermost part of the active area 206 (hereinafter referred to as the outermost body 214-3). The JTE 220 may have a second conductivity type. The termination area 207 is configured to disperse an electric field and is a very important region capable of increasing a breakdown voltage. To increase the breakdown voltage of the power semiconductor device 200A, an optimization design for the termination area 207 is required.

In some aspects, the bodies 214-1 and 214-2 described in relation to the JTE 220 in the termination area 207 may refer to the outermost body 214-3 unless otherwise described.

The JTE 220 may be disposed along the perimeter of the active area 206. The JTE 220 may be disposed horizontally with the outermost body 214-3. The outermost body 214-3 and the JTE 220 are formed on the drift layer 213 and may have the same conductivity type. The upper side of the outermost body 214-3 and the upper side of the JTE 220 may be located at the same horizontal line.

The lower side of the outermost body 214-3 may be positioned lower than the lower side of the JTE 220, but is not limited thereto.

The JTE 220 may comprise at least one blocking region 221 and a plurality of separation regions 222-1 to 222-n. The blocking region 221 and/or the plurality of separation regions 222-1 to 222-n may have a ring shape but are not limited thereto. For example, the blocking region 221 may have a ring shape along the circumference of the active area 206. Each of the plurality of separation regions 222-1 to 222-n may have a ring shape along the circumference of the active area 206. Each of the plurality of separation regions 222-1 to 222-n may have a ring shape along the circumference of the blocking region 221.

The blocking region 221 is referred to as a single junction, and the plurality of separation regions 222-1 to 222-n each having a ring shape may be referred to as a Floating Field Ring (FFR).

The blocking region 221 may primarily block an electric field. For example, the electric field generated in the active area 206 may be primarily blocked by the blocking region 221.

The blocking region 221 may be horizontally disposed on a side portion 214a of the outermost body 214-3. The blocking region 221 may contact the side portion 214a of the outermost body 214-3 but is not limited thereto. A lower side of the outermost body 214-3 may be positioned lower than a lower side of the blocking region 221. The depth of the blocking region 221 may be smaller than the depth of the outermost body 214-3 but is not limited thereto.

Meanwhile, the plurality of separation regions 222-1 to 222-n may serve to further block an electric field remaining even after being primarily blocked by the blocking region 221.

The plurality of separation regions 222-1 to 222-n may be disposed along a lateral direction of the blocking region 221. The blocking region 221 and the plurality of separation regions 222-1 to 222-n may be horizontally disposed. The plurality of separation regions 222-1 to 222-n may be located farther from the outermost body 214-3 than the blocking region 221. The plurality of separation regions 222-1 to 222-n may be sequentially disposed from the outermost body 214-3 toward the edge of the substrate 212. The blocking region 221 and each of the plurality of separation regions 222-1 to 222-n may have the same depth, but are not limited thereto.

The blocking region 221 and the plurality of separation regions 222-1 to 222-n may have the same conductivity type, for example, a second conductivity type. The blocking region 221 and the plurality of separation regions 222-1 to 222-n may be formed using the same mask. The bodies 214-1 and 214-2 (including the outermost body 214-3), the blocking region 221, and the plurality of separation regions 222-1 to 222-n may be formed using the same mask.

A plurality of separation intervals d11 to d13 may formed between the blocking region 221 and the plurality of separation regions 222-1 to 222-n. For example, an interval between the first separation regions 222-1 closest to the blocking region 221 among the plurality of separation regions 222-1 to 222-n and the blocking region 221 may be defined as a first separation interval d11. For example, intervals between the plurality of separation regions 222-1 to 222-n may be the remaining separation intervals d12 and d13.

As an example, the first separation interval d11 may be smaller than each of the remaining separation intervals d12 to d13.

As another example, the first separation interval d11 and the remaining separation intervals d12 to d13 may increase as the distance from the outermost body 214-3 increases.

As another example, the first separation interval d11 and each of the remaining separation intervals d12 to d13 may be the same.

The blocking region 221 may include at least one sub-blocking region 221a that is disposed within the blocking region 221. The sub-blocking regions 221a may be separated from each other. The blocking region 221 and the at least one sub-blocking region 221a may have the same conductivity type as the contact regions 216-1 and 216-2, for example, a second conductivity type. A dopant concentration (P+) of the sub-blocking region 221a may be greater than a dopant concentration (P-) of the blocking region 221. Dispersion of the electric field may be achieved even better by at least one or more sub-blocking region 221a.

Meanwhile, the blocking region 221 and the plurality of separation regions 222-1 to 222-n are deep junctions, and high implant energy is required to implement them. Accordingly, design rules are to increase the number of the plurality of separation regions 222-1 to 222-n while maintaining the predetermined distances d11 to d13. When the design rule is applied to a semiconductor design, the size of the power semiconductor device 200A increases. In addition, when the design rule is applied to a semiconductor design, it becomes difficult to design an optimized space and the breakdown voltage of the semiconductor design is lowered.

In particular, the first separation interval d11 is the smallest among the plurality of separation intervals d11 to d13, and is required to be, for example, 1 micrometer or less. This is because, as the first separation interval d11 is smaller, an optimized space may be designed without a desired design rule limitation. Therefore, the first separation regions 222-1 may be formed with a first distance d11 of 1 micrometer or less from the outermost body 214-3 so that there is a need for a new structure that may design an optimized space without design rule restrictions.

Hereinafter, a power semiconductor device 200B having a new structure for solving the above problems will be described with reference to FIGS. 7 to 9. That is, according to the power semiconductor device 200B according to the second aspect, it is possible to improve the optimal space design and withstand voltage performance.

### Second aspect

FIG. 7 is a cross-sectional view illustrating a power semiconductor device according to a second aspect. FIG. 8 is an enlarged cross-sectional view illustrating a JTE in the power semiconductor device according to the second aspect shown in FIG. 7.

The second aspect is the same as the first aspect except for the plurality of separation regions 222-1 to 222-n each comprising at least two or more sub-regions. In the second aspect, the same reference numerals are given to components having the same structure, shape and/or function as those in the first aspect, and detailed descriptions are omitted. The description omitted below may be replaced with the description of the first aspect (e.g., FIG. 6), and may be easily understood by the description of the first aspect in FIG. 6.

Referring to FIG. 7 and FIG. 8, the power semiconductor device 200B according to the second aspect may comprise a drain electrode 211, a substrate 212, a drift layer 213, bodies 214-1 and 214-2, source regions 215-1 and 215-2, contact regions 216-1 and 216-2, a gate electrode 217, an insulating layer 218, and a source electrode 219.

An active area 206 and a termination area 207 may be disposed on the substrate 212. As shown in FIG. 2 to FIG. 5 and FIG. 7, the active area 206 may comprise a plurality of active cells 206-1 to 206-4, and the termination area 207 may surround the active area 206.

The drift layer 213 may be disposed on the substrate 212, and the drain electrode 211 may be disposed below the substrate 212. The bodies 214-1 and 214-2 are disposed in the drift layer 213 in the active area 206, and the contact regions 216-1 and 216-2 and the source regions 215-1 and 215-2 are disposed in the bodies 214-1 and 214-2. In addition, a gate electrode 217 and the insulating layer 218 may be disposed on the drift layer 213 between the adjacent bodies 214-1 and 214-2. In this case, the insulating layer 218 may surround the gate electrode 217. The source electrode 219 may be disposed on the substrate 212. The source electrode 219 may be disposed on the active area 206 but is not limited thereto.

A semiconductor device may be configured by the drain electrode 211, the substrate 212, the drift layer 213, the bodies 214-1 and 214-2 included in each of the plurality of active cells 206-1 to 206-4 of the active area 206, the contact regions 216-1 and 216-2, the source regions 215-1 and 215-2, the gate electrode 217, the insulating layer 218, and the source electrode 219.

In addition, a JTE 220 may be disposed in the termination area 207. The JTE 220 may comprise at least one or more blocking regions 221 and a plurality of separation regions 222-1 to 222-n. The blocking region 221 and the separation regions 222-1 to 222-n may have the same conductivity type, for example, a second conductivity type. The blocking region 221 and the separation regions 222-1 to 222-n may have the same conductivity type as the bodies 214-1 and 214-2 (including the outermost body 214-3). A dopant concentration of the blocking region 221 may be equal to or greater than a dopant concentration of each the bodies 214-1 and 214-2. The dopant concentration of each of the separation regions 222-1 to 222-n may be equal to or greater than the dopant concentration of each of the bodies 214-1 and 214-2.

The blocking region 221 may be disposed adjacent to the outermost body 214-3. The blocking region 221 may be disposed horizontally with the outermost body 214-3. The blocking region 221 may be disposed on a side portion 214a of the outermost body 214-3. The blocking region 221 may contact the outermost body 214-3.

The depth of each of the bodies 214-1 and 214-2 (including the outermost body 214-3) may be greater than the depth of the blocking region 221 or the depth of each of each of the separation regions 222-1 to 222-n. At least one or more separation region among the plurality of separation regions 222-1 to 222-n may have the same conductivity type as the blocking region 221. The at least one or more separation region among the plurality of separation regions 222-1 to 222-n may have the same conductivity type as the bodies 214-1 and 214-2.

Meanwhile, each of the plurality of separation regions 222-1 to 222-n may comprise two or more sub-regions. The two or more sub-regions may have the same conductivity type as the blocking region 221. The two or more sub-regions may have the same conductivity type as the bodies 214-1 and 214-2.

For example, the two or more sub-regions may comprise first sub-regions 222-1a to 222-na and second sub-regions 222-1b to 222-nb.

The first sub-regions 222-1a to 222-na and the second sub-regions 222-1b to 222-nb may have different dopant concentrations. The first sub-regions 222-1a to 222-na and the second sub-regions 222-1b to 222-nb may be adjacent to each other. For example, the first sub-regions 222-1a to 222-na may be located closer to the outermost body 214-3 than the second sub-regions 222-1b to 222-nb. For example, the second sub-regions 222-1b to 222-nb may be located farther from the outermost body 214-3 than the first sub-regions 222-1a to 222-na.

The dose of each of the first sub-regions 222-1a to 222-na may be the same as the dose of each of the bodies 214-1 and 214-2 (including the outermost body 214-3). The dose of each of the second sub-regions 222-1b to 222-nb may be the same as the dose of each of the bodies 214-1 and 214-2. A first dose of each of the first sub-regions 222-1a to 222-na may be greater than a second dose of each of the second sub-regions 222-1b to 222-nb. The first dose of each of the first sub-regions 222-1a to 222-na may be greater than the dose of each of the bodies 214-1 and 214-2. A second dose of each of the second sub-region 222-1b to 222-nb may be the same as the dose of the blocking region 221. For example, the blocking region 221 and the second sub regions 222-1b to 222-nb may be formed on the drift layer 213 using the same mask, but this is not limited thereto.

Meanwhile, a plurality of separation intervals d21 to d23 may be defined between the blocking region 221 and the plurality of separation regions 222-1 to 222-n. For example, an interval between the first sub-region 222-1a of the first separation region 222-1 among the plurality of separation regions 222-1 to 222-n and the blocking region 221 may be defined as the first separation interval d21. For example, intervals between the plurality of first sub-regions 222-1a to 222-na of the plurality of separation regions 222-1 to 222-n may be defined as the remaining separation intervals d22 and d23.

Alternatively, the plurality of separation intervals d21 to d23 may be defined based on the second sub-regions 222-1b to 222-nb included in the plurality of separation regions 222-1 to 222-n, respectively., but are not limited thereto

As an example, the first separation interval d21 may be smaller than each of the remaining separation intervals d22 and d23.

As another example, the first separation interval d21 and the remaining separation intervals d22 and d23 may increase as the distance from the outermost body 214-3 increases.

Since the first separation interval d21 is implemented as a shallow junction and is formed by the first sub-regions 222-1a to 222-na each having a first dopant concentration greater than a second dopant concentration of each of the second sub-regions 222-1b to 222-nb, the first separation interval d21 may be smaller than the first separation interval d11 of the first aspect (FIG. 6). Accordingly, in the second aspect, since the first separation interval d21 is at least 1 micrometer or less, an optimized space may be achieved without design rule restrictions.

In some cases, the first sub-regions 222-1a to 222-na and the second sub-regions 222-1b to 222-nb may have different depths T1 and T2. For example, the first sub-regions 222-1a to 222-na may be shallow junctions, and the second sub-regions 222-1b to 222-nb may be deep junctions. For example, the first dopant concentration of each of the first sub-regions 222-1a to 222-na may be greater than the second dopant concentration of each of the second sub-regions 222-1b to 222-nb. Accordingly, the first sub-regions 222-1a to 222-na are located shallowly near the surface of the drift layer 213 and may be formed by an ion implantation process using low energy. In contrast, since the second sub-regions 222-1b to 222-nb are located deeper than at least the first sub-regions 222-1a to 222-na from the surface of the drift layer 213 and may be formed by an ion implantation process using high energy.

During the high-energy ion implantation process, since the second sub-regions 222-1b to 222-nb are formed deeply, the separation intervals between the second sub-regions 222-1b to 222-nb may create issues. However, since the second sub-regions 222-1b to 222-nb are located deeper than the first sub-regions 222-1a to 222-na, the electric field may be more appropriately dispersed.

Meanwhile, since the first sub-regions 222-1a to 222-na are formed shallowly during the low-energy ion implantation process, the separation intervals between the first sub-regions 222-1a to 222-na may be reduced as much as possible. Therefore, the first sub-regions 222-1a of the first separation region 222-1 that are closest to the outermost body 214-3 may be formed with a first separation interval d21 of at least 1 micrometer or less from the outermost body 214-3. By reducing the first separation interval d21 as much as possible, the electric field may be greatly dispersed by the first sub-region 222-1a of the first separation region 222-1 among the plurality of separation regions 222-1 to 222-n.

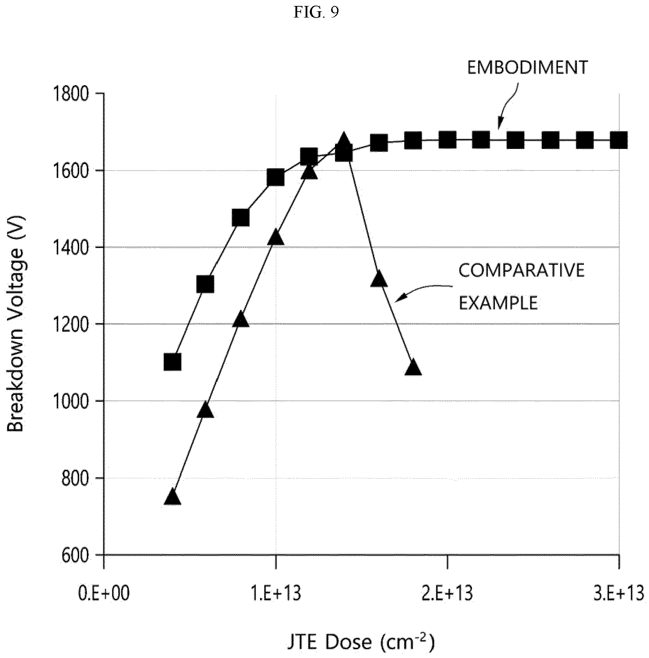

Similarly, the remaining separation intervals d22 and d23, which are intervals between sub-regions of each of the plurality of separation regions 222-1 to 222-n may also be formed narrowly by an ion implantation process having low energy. Accordingly, even if a very strong electric field is formed in the power semiconductor device 200B, the electric field that is generated during operation may be appropriately dispersed by the blocking region 221 and the plurality of separation regions 222-1 to 222-n, which each include at least two or more sub-regions, so that a breakdown voltage may be further increased. As shown in FIG. 9, the power semiconductor device 200B capable of withstanding a breakdown voltage of at least 1,600V or more may be implemented.

According to the second aspect, since each of the plurality of separation regions 222-1 to 222-n comprise two or more sub-regions, each of the plurality of separation intervals d21 to d23 may be smaller than each of the plurality of separation intervals d11 to d13 of the first aspect in FIG. 6.

As described above, each of the plurality of separation regions 222-1 to 222-n in the first aspect (FIG. 6) may be composed of a single region. At this time, since the ion implantation process is performed with high energy to realize a deep junction for forming the single region, it is difficult to narrow the plurality of separation intervals d11 to d13.

In contrast, according to the second aspect in FIG. 7 and FIG. 8, the plurality of separation regions 222-1 to 222-n may comprise two or more sub-regions, that is, the first sub-regions 222-1a to 222-na and the second sub-regions 222-1b to 222-nb. In this case, an ion implantation process having relatively low energy may be performed so that the first sub-regions 222-1a to 222-na closer to the outermost body 214-3 are implemented as shallow junctions. Accordingly, the plurality of separation intervals d21 to d23 may be narrowed as compared to the first aspect in FIG. 6 and an optimized space may be designed without the design rule restrictions noted above.

In addition, since the electric field may appropriately be dispersed by the second sub-regions 222-1b to 222-nb, with each having a second dopant concentration smaller than a first dopant concentration of each of the first sub-regions 222-1a to 222-na, a desired breakdown voltage may be achieved. In other words, in each of the plurality of separation regions 222-1 to 222-n, an optimized space may be designed by the first sub-regions 222-1a to 222-na that comports with the design rule restrictions, and a desired breakdown voltage may be achieved through a dispersion of electric field by the second sub-region 222-1b to 222-nb.

When the dopant concentration of each of the separation regions 222-1 to 222-n is lowered to disperse the electric field, the design rule may increase due to the high-energy ion implantation process performed to implement the deep junction. Conversely, when the dose of each of the separation regions 222-1 to 222-n is increased to reduce the design rule, the electric field is concentrated in the separation regions 222-1 to 222-n, and the withstanding voltage may rather decrease. The second aspect may have a unique technical effect that may simultaneously solve the contradiction between the two. That is, in the second aspect, two or more sub-regions are included in each of the plurality of separation regions 222-1 to 222-n so that, for example, design rules may be reduced by the first sub-regions 222-1a to 222-na closer to the outermost body 214-3, and for example, a breakdown voltage of 1, 600V or more may be achieved by appropriate dispersion of an electric field by the second sub-regions 222-1b to 222-nb as shown in FIG. 9. Since the product reliability of the power semiconductor device 200B according to the second aspect from which the corresponding technical effect may be obtained, it may be applied to various downstream industries requiring a higher breakdown voltage, such as ultra-high voltage power generation, power transmission and distribution facilities, or electric vehicles.

Meanwhile, the upper sides 1A of the first sub-regions 222-1a to 222-na and the upper sides 1B of the second sub-regions 222-1b to 222-nb are located at the same horizontal line, and the lower sides 1D of the second sub-regions 222-1b to 222-nb may be located lower than the lower sides 1C of the first sub-regions 222-1a to 222-na.

The first sub-regions 222-1a to 222-na and/or the second sub-regions 222-1b to 222-nb may be formed on the drift layer 213 using an ion implantation process. When the upper side of the drift layer 213 has a flat surface, the first sub-regions 222-1a to 222-na and/or the second sub-regions 222-1a to 222-na are formed by impurities including ions implanted through the upper side of the drift layer 213. area may be formed. Accordingly, the upper side 1A of the first sub-regions 222-1a to 222-na formed in the drift layer 213 and the upper side 1B of the second sub-regions 222-1b to 222-nb may be located at the same horizontal line.

An ion implantation process may be performed using different energies to form the first sub-regions 222-1a to 222-na and the second sub-regions 222-1b to 222-nb. For example, the first sub-regions 222-1a to 222-na may be formed by an ion implantation process with low energy, and the second sub-regions 222-1b to 222-nb may be formed by an ion implantation process with high energy. Accordingly, the lower sides 1D of the second sub-regions 222-1b to 222-nb formed by the high-energy ion implantation process may be positioned lower than the lower sides 1C of the first sub-regions 222-1a to 222-na formed by the low-energy ion implantation process. That is, the impurities forming the second sub-regions 222-1b to 222-nb may be formed deeper from the upper side of the drift layer 213 than the impurities forming the first sub-regions 222-1a to 222-na. The lower sides 1D of the deeper second sub-regions 222-1b to 222-nb may be positioned lower than the lower sides 1C of the first sub-regions 222-1a to 222-na.

Meanwhile, the plurality of separation regions 222-1 to 222-n may comprise overlapping regions 222-1c to 222-nc, respectively. The overlapping region 222-1c to 222-nc may comprise a part of the first sub-region 222-1a to 222-na and a part of the second sub-region 222-1b to 222-nb. That is, the overlapping region 222-1c to 222-nc may be formed by mixing the first impurities for forming the first sub-regions 222-1a to 222-na and the second impurities for forming the second sub-regions 222-1b to 222-nb.

For example, after the first sub-regions 222-1a to 222-na are formed in the drift layer 213 using the first impurity, the second sub-region 222-1b to 222-nb may be formed in some parts of the pre-formed first sub-regions 222-1a to 222-na and the drift layer 213 in contact with some parts of the first sub-regions 222-1a to 222-na. Thus, the overlapping regions 222-1c to 222-nc may be formed in some parts of the first sub-regions 222-1a to 222-na, and the second sub-regions 222-1b to 222-nb may be formed in the first sub-regions 222-1a to 222-na.

The lower sides 1D of the second sub-regions 222-1b to 222-nb may be located below the overlapping regions 222-1c to 222-nc. As described above, the energy of the ion implantation process used to form the second sub-regions 222-1b to 222-nb may be greater than the energy of the implantation process used to form the first sub-regions 222-1a to 222-na. Accordingly, the second impurities may be implanted into some parts of the pre-formed first sub-regions 222-1a to 222-na and the drift layer 213 in contact with some parts of the first sub-regions 222-1a to 222-na through an ion implantation process having high energy. Thus, some of the second impurities may be implanted into some parts of the first sub-regions 222-1a to 222-na, and they may be mixed with the first impurities included in some parts of the first sub-regions 222-1a to 222-na to form the overlapping regions 222-1c to 222-nc. Another part of the second impurity is implanted into the drift layer 213 on the lower portion of some parts of the first sub-region 222-1a to 222-na by passing through some parts of the first sub-regions 222-1a to 222-na so that a part of the second sub-region 222-1b to 222-nb may be formed. Another part of the second impurity is implanted into the drift layer 213 in contact with some parts of the first sub-regions 222-1a to 222-na to form the second sub-regions 222-1b to 222-nb. Therefore, the lower side 1D of the second sub-regions 222-1b to 222-nb may be located below the overlapping regions 222-1c to 222-nc.

Although it has been described that the second sub-regions 222-1b to 222-nb are formed after the first sub-regions 222-1a to 222-na are formed, the order may be changed.

Meanwhile, as shown in FIG. 9, since the plurality of separation regions 222-1 to 222-n are included, it may be seen that a constant breakdown voltage is maintained regardless of the increase or decrease in dopant concentration (e.g., dopant concentrations can be the same as a previous process) in the aspect compared to the comparative example. The comparative example is a power semiconductor device without a plurality of separation regions 222-1 to 222-n, and the aspect is a power semiconductor device with a plurality of separation regions 222-1 to 222-n. In particular, the aspect is a power semiconductor device in which a plurality of separation regions 222-1 to 222-n are separated into two or more sub-regions, and a breakdown voltage of at least 1, 600V or more may be maintained constant regardless of an increase or decrease in dose.

The above detailed description should not be construed as limiting in all respects and should be considered illustrative. The scope of the aspect should be determined by reasonable interpretation of the appended claims, and all changes within the equivalent range of the aspect are included in the scope of the aspect.

## Claims

1. A power semiconductor device (200B), comprising:
a substrate (212);
a drift layer (213) formed in the substrate including an active area (206) having doped regions and a termination area (207) configured to surround the active area; and
a junction termination extension (JTE, 220) in the termination area,
wherein the substrate and the drift layer comprise a first conductivity type,
wherein the doped regions and the JTE comprise a second conductivity type,
wherein the JTE comprises at least one blocking region (221) adjacent to an edge of the active area and a plurality of separation regions (222-1 to 222-n),
wherein each separation region of the plurality of separation regions comprises two or more separation sub-regions, and
wherein the two or more separation sub-regions are configured to have a different dopant concentrations.

2. The power semiconductor device of claim 1, wherein each separation region comprises:
a first separation sub-region (222-1a to 222-na) comprising a first dopant concentration; and
a second separation sub-region (222-1b to 222-nb) comprising a second dopant concentration,
wherein the first dopant concentration is configured to be greater than the second dopant concentration.

3. The power semiconductor device of claim 2, wherein the first separation sub-region is configured to be located closer to the edge of the active area than the second separation sub-region.

4. The power semiconductor device of any one of the preceding claims,
wherein the plurality of separation regions comprises a first separation region (222-1) adjacent to the at least one blocking region and a second separation region (222-2) adjacent to the first separation region,
wherein a distance between the first separation region and the at least one blocking region is less than a distance between the first separation region and the second separation region.

5. The power semiconductor device of any one of the preceding claims, wherein a distance between adjacent separation regions is correlated to a distance of an inner separation region of the adjacent separation region to the at least one blocking region.

6. The power semiconductor device of any one of the preceding claims in combination with claim 2, wherein the first separation sub-region and the second separation sub-region are configured to have different depths.

7. The power semiconductor device of claim 6, wherein an upper side of the first separation sub-region and an upper side of the second separation sub-region are configured to be located at a single horizontal line, and
wherein a lower side of the second separation sub-region is configured to be located lower than a lower side of the first separation sub-region.

8. The power semiconductor device of any one of the preceding claims in combination with claim 2, wherein each of the plurality of separation regions comprises an overlapping region (222-1c to 222nc) comprising a part of the first separation sub-region and a part of the second separation sub-region.

9. The power semiconductor device of claim 8, wherein the lower side of the second separation sub-region is configured to be located below the overlapping region.

10. The power semiconductor device of any one of the preceding claims, wherein the at least one blocking region comprises a plurality of sub-blocking regions (221a), wherein each of the plurality of sub-blocking regions include a doping concentration corresponding to contact regions (216-1 and 216-2) in the active area, wherein the plurality of sub-blocking regions are formed while doping the contact regions.

11. The power semiconductor device of any one of the preceding claims, wherein when a plurality of separation intervals (d21 to d23) are configured by a first separation interval (d21) and remaining separation intervals (d22 and d23), with the first separation interval being smaller than each of the remaining separation intervals,
wherein the first separation interval is between a first sub-region (222-1a) of a first separation region (222-1) closest to the at least one blocking region among the plurality of separation regions and the at least one blocking region, and
wherein the remaining spacing intervals are configured between the plurality of first sub-regions of the plurality of separation regions.

12. The power semiconductor device of claim 11, wherein as a distance from the outermost body increases, the first separation interval and the remaining separation intervals are configured to increase.

13. The power semiconductor device of any one of the preceding claims, wherein a first dose of the first separation sub-region or a second dose of the second separation sub-region is configured to be equal to a dopant concentration of the doped regions.

14. The power semiconductor device of any one of the preceding claims, wherein the at least one blocking region and the plurality of separation regions are configured to have a ring shape.

15. A power converter (1000), comprising:
a plurality of power semiconductor modules (100A, 100B and 100C),
wherein each of the plurality of power semiconductor modules comprises a plurality of power semiconductor devices of any one of the preceding claims.

## Amended claims

### Amended claims in accordance with Rule 137(2) EPC.

1. A power semiconductor device (200B), comprising:
a substrate (212);
a drift layer (213) formed in the substrate including an active area (206) having doped regions and a termination area (207) configured to surround the active area; and
a junction termination extension, JTE, (220) in the termination area,
wherein the substrate and the drift layer comprise a first conductivity type,
wherein the doped regions and the JTE comprise a second conductivity type,
wherein the JTE comprises at least one blocking region (221) in contact with an outermost body (214-3) of the active area and a plurality of separation regions (222-1 to 222-n), wherein each separation region of the plurality of separation regions (222-1 to 222-n) comprises two or more separation sub-regions, and
wherein the two or more separation sub-regions are configured to have different dopant concentration,
wherein the at least one blocking region (221) and the plurality of separation regions (222-1 to 222-n) are disposed at an upper surface of the drift layer and the plurality of separation regions (222-1 to 222-n) are disposed along a lateral direction of the at least one blocking region (221),
wherein the at least one blocking region (221) includes the second conductivity type and the outermost body (214-3) includes the second conductivity type, and
wherein a lower side of the outermost body (214-3) is positioned lower than both a lower side of the at least one blocking region (221) and lower sides of plurality of separation regions (222-1 to 222-n).

2. The power semiconductor device of claim 1, wherein each separation region comprises:
a first separation sub-region (222-1a to 222-na) comprising a first dopant concentration; and
a second separation sub-region (222-1b to 222-nb) comprising a second dopant concentration, wherein the first dopant concentration is configured to be greater than the second dopant concentration.

3. The power semiconductor device of claim 2, wherein the first separation sub-region is configured to be located closer to the outermost body (214-3) of the active area than the second separation sub-region.

4. The power semiconductor device of any one of the preceding claims,
wherein the plurality of separation regions comprises a first separation region (222-1) adjacent to the at least one blocking region and a second separation region (222-2) adjacent to the first separation region,
wherein a distance between the first separation region and the at least one blocking region is less than a distance between the first separation region and the second separation region.

5. The power semiconductor device of any one of the preceding claims, wherein an interval of a first separation region (222-1) of the plurality of separation regions closest to the at least one blocking region (221) is defined as a first separation interval (d11), and intervals between adjacent separation regions (222-2, 222-n) of the plurality of separation regions are defined as remaining separation intervals (d12, d13),
wherein the first separation interval (d11) is smaller than each of the remaining separation intervals (d12, d13).

6. The power semiconductor device of claim 5, wherein the first separation interval (d11) is 1 µm or less.

7. The power semiconductor device of claim 5 or 6, wherein, as a distance from the outermost body (214-3) increases, the first separation interval (d11) and the remaining separation intervals (d12, d13) are configured to increase.

8. The power semiconductor device of claim 2, wherein each of the plurality of separation regions comprises an overlapping region (222-1c to 222nc) comprising a part of the first separation sub-region and a part of the second separation sub-region.

9. The power semiconductor device of claim 8, wherein the lower side of the second separation sub-region is configured to be located below the overlapping region.

10. The power semiconductor device of any one of the preceding claims, wherein the at least one blocking region comprises a plurality of sub-blocking regions (221a), wherein each of the plurality of sub-blocking regions include a doping concentration corresponding to contact regions (216-1 and 216-2) in the active area, wherein the plurality of sub-blocking regions are formed while doping the contact regions.

11. The power semiconductor device any one of the preceding claims, wherein an interval between a first separation sub-region (222-1a) of a first separation region (222-1) of the plurality of separation regions closest to the at least one blocking region (221) is defined as a first separation interval (d21), and intervals between the first separation sub-region (222-1a) and the second separation sub-region (222-1b), respectively, of adjacent separation regions (222-2, 222-n) of the plurality of separation regions are defined as remaining separation intervals (d22, d23),
wherein the first separation interval (d21) is smaller than each of the remaining separation intervals (d22, d23).

12. The power semiconductor device of claim 11, wherein, as a distance from the outermost body (214-3) increases, the first separation interval (d21) and the remaining separation intervals (d22, d23) are configured to increase.

13. The power semiconductor device of any one of the preceding claims, wherein a conductivity type of the first separation sub-region and the second separation sub-region is equal to the outermost body (214-3).

14. The power semiconductor device of any one of the preceding claims, wherein the at least one blocking region and the plurality of separation regions are configured to have a ring shape.

15. A power converter (1000), comprising:
a plurality of power semiconductor modules (100A, 100B and 100C),
wherein each of the plurality of power semiconductor modules comprises the power semiconductor device according to any one of the preceding claims.
